(19) Europäisches Patentamt
European Patent Office
Office européen des brevets

(11) EP 4 401 529 A1

(12) **EUROPEAN PATENT APPLICATION**
published in accordance with Art. 153(4) EPC

(43) Date of publication:
**17.07.2024 Bulletin 2024/29**

(21) Application number: **22867328.1**

(22) Date of filing: **05.09.2022**

(51) International Patent Classification (IPC):
***H10K 50/00*** *(2023.01)* ***H10K 50/30*** *(2023.01)*

(86) International application number:
**PCT/JP2022/033264**

(87) International publication number:
**WO 2023/038006 (16.03.2023 Gazette 2023/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.09.2021 JP 2021145744**

(71) Applicant: **Hodogaya Chemical Co., Ltd.**
**Tokyo, 105-0021 (JP)**

(72) Inventors:
- **HIRAYAMA, Yuta**
**Tokyo 105-0021 (JP)**
- **KASE, Kouki**
**Tokyo 105-0021 (JP)**
- **CHIBA, Eriko**
**Tokyo 105-0021 (JP)**
- **HAYASHI, Shuichi**
**Tokyo 105-0021 (JP)**

(74) Representative: **Forstmeyer, Dietmar et al**
**Boeters & Lieck**
**Oberanger 32**
**80331 München (DE)**

# (54) ORGANIC ELECTROLUMINESCENT ELEMENT

(57) An object of the present invention is to provide an organic EL element that has high efficiency, a low driving voltage, and a long lifespan, by combining various materials for organic EL elements, the materials having excellent hole injecting/transporting performance, such that the properties of the individual materials can be effectively exhibited. Focusing on the finding that combination use of materials for hole-transporting layers having specific mobilities enables efficient transport of holes injected from an anode side and enhances electron blockability, an organic EL element having high efficiency, a low driving voltage, and a long lifespan was produced by using a specific arylamine compound for the hole-transporting layer, and thus, the present invention was accomplished.

Fig. 3

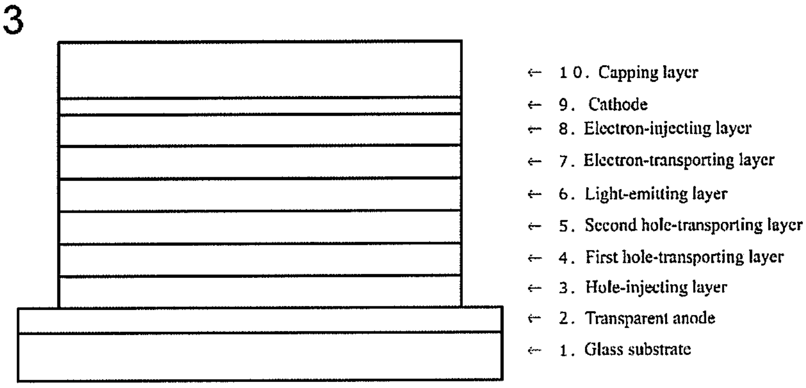


EP 4 401 529 A1

## Description

### Technical Field

The present invention relates to an organic electroluminescent element (hereinafter referred to simply as "organic EL element"), which is a self-emissive element favorably used in various display devices, and more particularly relates to an organic electroluminescent element including a compound having a specific mobility.

### Background Art

Since organic EL elements are self-emissive elements, they have larger brightness and better viewability than elements including liquid crystals, and can thus provide a clearer display. For these reasons, active studies have been carried out on organic EL elements.

In 1987, C. W. Tang et al. of Eastman Kodak Company developed an element having a layered structure in which various functions were assigned to different materials, and thus made a practical organic EL element including organic materials. They made an organic EL element having a layered structure including a layer of a fluorescent substance capable of transporting electrons and a layer of an organic substance capable of transporting holes, and injected both charges into the layer of the fluorescent substance to thereby cause the layer to emit light, and the organic EL element thus achieved a luminance as high as 1,000 cd/$m^2$ or more at a voltage of 10 V or less (see Patent Literatures 1 and 2, for example).

Organic EL elements have been heretofore much improved to put them to practical use. Electroluminescent elements with a bottom emission structure, which emit light from the bottom thereof, have been suggested in which an anode, a hole-injecting layer, a hole-transporting layer, a light-emitting layer, an electron-transporting layer, an electron-injecting layer, and a cathode are sequentially provided on a substrate to subdivide various functions in the multi-layered structure even further, and such electroluminescent elements successfully have high efficiency and durability (see Non-Patent Literature 1, for example).

Recently, light-emitting elements with a top emission structure are also coming into use. In the light-emitting element with a top emission structure, a metal having a high work function is used as an anode, and light is extracted from the top side of the element. A light-emitting element with a bottom emission structure results in a limited area of the light-emitting portion, since light is extracted from its bottom side, which has circuits for pixels. In contrast, the light-emitting element with a top emission structure advantageously enables a large light-emitting area since light extracted from the top side is not blocked by the circuits for pixels.

In an organic EL element, the charges injected from both electrodes recombine in the light-emitting layer, thereby producing light emission, and how efficiently the both charges, i.e., the holes and the electrons, are transported to the light-emitting layer is of importance. Thus, the element needs to have excellent carrier balance. Additionally, higher luminous efficiency can be achieved by improving hole injectability and also electron block-ability (the ability to block electrons injected from the cathode) to thereby increase the probability of recombination of holes and electrons, and furthermore, by confining excitons generated in the light-emitting layer.

N,N'-diphenyl-N,N'-di($\alpha$-naphthyl)benzidine (NPD) and various aromatic amine derivatives are known as hole-transporting materials that have been heretofore used for organic EL elements (see Patent Literatures 1 and 2, for example). NPD has good hole transportability, but has a glass transition point (Tg), which is a measure of heat resistance, as low as 96°C. Such a glass transition point cause a deterioration of the characteristics of elements due to crystallization of NPD under high-temperature conditions (see Non-Patent Literature 3, for example). Moreover, although the aromatic amine derivatives disclosed in Patent Literatures described above include compounds having an excellent hole mobility of $10^{-3}$ $cm^2/Vs$ or higher (see Patent Literatures 1 and 2, for example), the electron block-ability thereof is insufficient. Thus, when using such a compound, some electrons pass through the light-emitting layer, and unfortunately, no increase in luminous efficiency can be expected. Accordingly, in order to further increase the efficiency, materials that have higher electron block-ability, higher stability in the form of a thin film, and higher heat resistance are needed. Therefore, organic EL elements are used that have a structure in which an additional hole-transporting layer having high electron block-ability is provided between the hole-transporting layer and the light-emitting layer.

Arylamine compounds having a substituted carbazole structure have been suggested as compounds improved in the properties including heat resistance and hole injectability (see Patent Literatures 3 and 4, for example). In elements in which these compounds are used for the hole-injecting layer or a hole-transporting layer, heat resistance, luminance efficiency, etc. thereof are improved, but are still insufficient. There is a demand for a further decrease in driving voltage and a further increase in luminance efficiency.

For improving the properties of organic EL elements and improving the production yield of elements, it is required to combine materials that are excellent in hole/electron injecting/transporting performance, stability in the form of a thin film, and durability to obtain an element that is capable of causing holes and electrons to recombine highly efficiently

and thus has high luminance efficiency, a low driving voltage, and a long lifespan.

Also, for improving the properties of organic EL elements, it is required to combine materials that are excellent in hole/electron injecting/transporting performance, stability in the form of a thin film, and durability to obtain an element that has a good carrier balance, high efficiency, a low driving voltage, and a long lifespan.

Citation List

Patent Literature

Patent Literature 1: US 5792557
Patent Literature 2: US 5639914
Patent Literature 3: US 8021764B2
Patent Literature 4: US 8394510B2
Patent Literature 5: WO 2014/009310
Patent Literature 6: US 2019/0006596A1
Patent Literature 7: US 2016/0118591A1
Patent Literature 8: US 2017/0179398A1

Non-Patent Literature

Non-Patent Literature 1: Proceedings of the 9th Meeting of the Japan Society of Applied Physics, pp. 55-61 (2001)
Non-Patent Literature 2: Appl. Phys. Let., 98, 083302 (2011)
Non-Patent Literature 3: Proceedings of the 3rd Meeting of the Japan OLED Forum, pp. 13-14 (2006)

Summary of Invention

It is an object of the present invention to provide an organic EL element that has high efficiency, a low driving voltage, and a long lifespan, by combining various materials for organic EL elements, the materials having excellent hole injecting/transporting performance, such that the properties of the individual materials can be effectively exhibited.

An organic EL element to be provided by the present invention should have the following physical properties: (1) high luminance efficiency and high power efficiency, (2) a low actual driving voltage, and (3) a long lifespan.

To achieve the above-described object, the inventors of the present invention have conducted research, and have found that combination use of materials for hole-transporting layers having specific mobilities enables efficient transport of holes injected from the anode side and also brings about high electron block-ability, and that an organic EL element having high efficiency, a low driving voltage, and a long lifespan can therefore be obtained. As a result, the present invention has been accomplished.

Specifically, the present invention provides the following organic EL element.

1) An organic electroluminescent element having at least an anode, a first hole-transporting layer, a second hole-transporting layer, a light-emitting layer, an electron-transporting layer, and a cathode in this order,

wherein the second hole-transporting layer contains an amine compound represented by the general formula (1) or (2) below, and

a mobility of the first hole-transporting layer, $\mu1$, and a mobility of the second hole-transporting layer, $\mu2$, satisfy the formulae (A) and (B) below simultaneously:

$$\mu2 > 1.0\times10^{-3}\ \mathrm{cm^2/Vs} \qquad (A),$$

and

$$\mu2/\mu1 > 1.5 \qquad (B).$$

[Chem. 1]

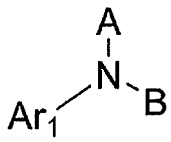

(1)

In the formula (1), A and B may be the same or different and each represent a monovalent group represented by the general formula (1-1) below; and

$Ar_1$ represents a substituted or unsubstituted aromatic hydrocarbon group or a substituted or unsubstituted fused polycyclic aromatic group.

[Chem. 2]

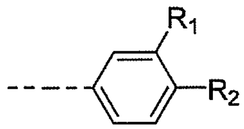

(1-1)

In the formula (1-1), the dashed line represents a binding site; and

$R_1$ and $R_2$ may be the same or different and each represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted fused polycyclic aromatic group, or a substituted or unsubstituted aryloxy group. $R_1$ and $R_2$ may be bonded to each other via a single bond, a substituted or unsubstituted methylene group, an oxygen atom, or a sulfur atom to form a ring.

[Chem. 3]

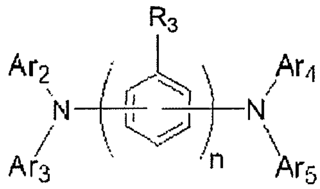

(2)

In the formula (2), $Ar_2$, $Ar_3$, $Ar_4$, and $Ar_5$ may be the same or different and each represent a substituted or unsubstituted aromatic hydrocarbon group or a substituted or unsubstituted fused polycyclic aromatic group;

$R_3$ represents a hydrogen atom, a substituted or unsubstituted aromatic hydrocarbon group, or a substituted or unsubstituted fused polycyclic aromatic group, and when there are plural $R_3$, they may be the same or different; and n represents an integer of 1 to 5.

2) The organic electroluminescent element as set forth in clause 1), wherein, in the monovalent group represented by the general formula (1-1), $R_1$ and $R_2$ may be the same or different and each represent a hydrogen atom, a substituted or unsubstituted aromatic hydrocarbon group having 6 or 30 carbon atoms or a substituted or unsubstituted fused polycyclic aromatic group having 6 to 30 carbon atoms.

3) The organic electroluminescent element as set forth in clause 1), wherein, in amine compounds represented by the general formulae (1) and (2), $Ar_1$, $Ar_2$, $Ar_3$, $Ar_4$, and $Ar_5$ may be the same or different and each represent a substituted or unsubstituted aromatic hydrocarbon group having 6 to 30 carbon atoms or a substituted or unsubstituted

fused polycyclic aromatic group having 6 to 30 carbon atoms.

4) The organic electroluminescent element as set forth in any one of clauses 1) to 3), wherein the mobility of the first hole-transporting layer, $\mu 1$, is $1.5 \times 10^{-3}$ $cm^2/Vs$ or less.

5) The organic electroluminescent element as set forth in any one of clauses 1) to 4), wherein the mobility of the second hole-transporting layer, $\mu 2$, is $2.0 \times 10^{-3}$ $cm^2/Vs$ or more.

6) The organic electroluminescent element as set forth in any one of clauses 1) to 5), wherein the first hole-transporting layer has a film thickness of more than 30 nm and less than 200 nm, and the second hole-transporting layer has a film thickness of more than 3 nm and less than 20 nm.

Examples of the "aromatic hydrocarbon group" or the "fused polycyclic aromatic group" of the "substituted or unsubstituted aromatic hydrocarbon group" or the "substituted or unsubstituted fused polycyclic aromatic group" represented by $Ar_1$ in the general formula (1) specifically include a phenyl group, a biphenylyl group, a terphenylyl group, a naphthyl group, an anthracenyl group, a phenanthrenyl group, a fluorenyl group, a spirobifluorenyl group, an indenyl group, a pyrenyl group, a perylenyl group, a fluoranthenyl group, a triphenylenyl group, and also aryl groups having 6 to 30 carbon atoms. A phenyl group, a biphenylyl group, a terphenylyl group, a naphthyl group, an anthracenyl group, a phenanthrenyl group, a fluorenyl group, and a spirobifluorenyl group are preferred. A substituent and a benzene ring substituted with the substituent, or a plurality of substituents on the same benzene ring, may be bonded to each other via a single bond, a substituted or unsubstituted methylene group, a substituted or unsubstituted amine group, an oxygen atom, or a sulfur atom to form a ring.

Examples of the "substituent" in the "substituted or unsubstituted aromatic hydrocarbon group" or the "substituted or unsubstituted fused polycyclic aromatic group" represented by $Ar_1$ in the general formulae (1) specifically include a deuterium atom, a cyano group, or a nitro group; a halogen atom such as a fluorine atom, a chlorine atom, a bromine atom, or an iodine atom; a silyl group such as a trimethylsilyl group or a triphenylsilyl group; a linear or branched alkyl group having 1 to 6 carbon atoms such as a methyl group, an ethyl group, or a propyl group; a linear or branched alkyloxy group having 1 to 6 carbon atoms such as a methyloxy group, an ethyloxy group, or a propyloxy group; an alkenyl group such as a vinyl group or an allyl group; an aryloxy group such as a phenyloxy group or a tolyloxy group; an arylalkyloxy group such as a benzyloxy group or a phenethyloxy group; an aromatic hydrocarbon group or a fused polycyclic aromatic group such as a phenyl group, a biphenylyl group, a terphenylyl group, a naphthyl group, an anthracenyl group, a phenanthrenyl group, a fluorenyl group, a spirobifluorenyl group, an indenyl group, a pyrenyl group, a perylenyl group, a fluoranthenyl group, or a triphenylenyl group; and an aromatic heterocyclic group such as a pyridyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, or a carbolinyl group. These substituents may be further substituted with the above-listed substituents. Furthermore, such a substituent and a benzene ring substituted with the substituent, or a plurality of substituents on the same benzene ring, may be bonded to each other via a single bond, a substituted or unsubstituted methylene group, a substituted or unsubstituted amine group, an oxygen atom, or a sulfur atom to form a ring.

In the general formula (1), $Ar_1$ preferably represents a phenyl group or a biphenylyl group.

Examples of the "linear or branched alkyl group having 1 to 6 carbon atoms", the "cycloalkyl group having 5 to 10 carbon atoms", or the "linear or branched alkenyl group having 2 to 6 carbon atoms" of the "linear or branched alkyl group having 1 to 6 carbon atoms and optionally having a substituent", the "cycloalkyl group having 5 to 10 carbon atoms and optionally having a substituent", or the "linear or branched alkenyl group having 2 to 6 carbon atoms and optionally having a substituent" represented by $R_1$ and $R_2$ in the general formula (1-1) specifically include a methyl group, an ethyl group, an n-propyl group, an isopropyl group, an n-butyl group, an isobutyl group, a tert-butyl group, an n-pentyl group, an isopentyl group, a neopentyl group, an n-hexyl group, a cyclopentyl group, a cyclohexyl group, a 1-adamantyl group, a 2-adamantyl group, a vinyl group, an allyl group, an isopropenyl group, and a 2-butenyl group. Such a substituent and the benzene ring substituted with the substituent, or a plurality of substituents on the same benzene ring, may be bonded to each other via a single bond, a substituted or unsubstituted methylene group, a substituted or unsubstituted amine group, an oxygen atom, or a sulfur atom to form a ring.

Examples of the "linear or branched alkyloxy group having 1 to 6 carbon atoms" or the "cycloalkyloxy group having 5 to 10 carbon atoms" of the "linear or branched alkyloxy group having 1 to 6 carbon atoms and optionally having a substituent" or the "cycloalkyloxy group having 5 to 10 carbon atoms and optionally having a substituent" represented by $R_1$ and $R_2$ in the general formula (1-1) specifically include a methyloxy group, an ethyloxy group, an n-propyloxy group, an isopropyloxy group, an n-butyloxy group, a tert-butyloxy group, an n-pentyloxy group, an n-hexyloxy group, a cyclopentyloxy group, a cyclohexyloxy group, a cycloheptyloxy group, a cyclooctyloxy group, a 1-adamantyloxy group, and a 2-adamantyloxy group. Such a substituent and the benzene ring substituted with the substituent, or a plurality of substituents on the same benzene ring, may be bonded to each other via a single bond, a substituted or unsubstituted methylene group, a substituted or unsubstituted amine group, an oxygen atom, or a sulfur atom to form a ring.

Examples of the "aryloxy group" of the "substituted or unsubstituted aryloxy group" represented by $R_1$ and $R_2$

in the general formula (1-1) specifically include a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, and a perylenyloxy group.

The "substituted or unsubstituted aromatic hydrocarbon group" or the "substituted or unsubstituted fused polycyclic aromatic group" represented by $R_1$ and $R_2$ in the general formula (1-1) has the same meaning as that of the "substituted or unsubstituted aromatic hydrocarbon group" or the "substituted or unsubstituted fused polycyclic aromatic group" represented by $Ar_1$ in the general formula (1).

In the general formula (1-1), $R_1$ and $R_2$ may be the same or different and each preferably represent a substituted or unsubstituted aromatic hydrocarbon group or a substituted or unsubstituted fused polycyclic aromatic group, more preferably a substituted or unsubstituted aromatic hydrocarbon group, and even more preferably a phenyl group.

The following is also preferable: one of $R_1$ and $R_2$ represents a methyl group optionally having a substituent, the other represents a phenyl group, and the methyl group and the phenyl group are bonded to each other via a single bond to form a five-membered ring.

The "substituted or unsubstituted aromatic hydrocarbon group" or the "substituted or unsubstituted fused polycyclic aromatic group" represented by $Ar_2$, $Ar_3$, $Ar_4$, and $Ar_5$ in the general formula (2) has the same meaning as that of the "substituted or unsubstituted aromatic hydrocarbon group" or the "substituted or unsubstituted fused polycyclic aromatic group" represented by $Ar_1$ in the general formula (1).

The "substituted or unsubstituted aromatic hydrocarbon group" or the "substituted or unsubstituted fused polycyclic aromatic group" represented by $R_3$ in the general formula (2) has the same meaning as that of the "substituted or unsubstituted aromatic hydrocarbon group" or the "substituted or unsubstituted fused polycyclic aromatic group" represented by $Ar_1$ in the general formula (1).

In the formula (2), $Ar_2$, $Ar_3$, $Ar_4$, and $Ar_5$ may be the same or different and each preferably represent a substituted or unsubstituted aromatic hydrocarbon group, and more preferably a phenyl group or a biphenylyl group.

When there are more than one $R_3$ in the general formula (2), they may be the same or different. $R_3$ preferably represents a hydrogen atom or a substituted or unsubstituted aromatic hydrocarbon group, and more preferably a hydrogen atom or a phenyl group,

In the general formula (2), where n represents an integer of 1 to 5, n preferably represents 2, 3, 4, or 5, and more preferably 3.

The organic EL element of the present invention has the first hole-transporting layer and the second hole-transporting layer whose mobilities satisfy the formulae (A) and (B) simultaneously and therefore has the following properties: (1) good hole-injecting properties, (2) high luminance efficiency, and (3) a long lifespan. The combination of the first hole-transporting layer and the second hole-transporting layer according to the present invention is suitable for organic EL elements.

In the present invention, the compound used for the first hole-transporting layer and that for the second hole-transporting layer are combined such that the ratio of the mobility of the latter to that of the former is more than 1.5. This enhances carrier transport into the light-emitting layer, thereby reducing the carrier-exciton quenching effect caused by accumulation of carriers at the interface between the second hole-transporting layer and the light-emitting layer, and high luminance efficiency can be thus obtained. Also, the combination use of the compounds as described above prevents deterioration and quenching due to decomposition of the compounds caused by accumulation of carriers and excitons at the interface between the second hole-transporting layer and the light-emitting layer, and an element having a long lifespan can be thus obtained.

In the present invention, the hole-transporting layer has a two-layer structure consisting of the first hole-transporting layer and the second hole-transporting layer, and the second hole-transporting layer, which is located on the side adjacent to the light-emitting layer, contains an arylamine compound represented by the general formula (1) or (2) above. This configuration can make the most of the electron blocking performance of the compound, whereby the organic EL element has even higher efficiency and an even longer lifespan.

Furthermore, in the present invention, compounds that are greatly different in mobility and satisfy the above formulae (A) and (B) simultaneously are used as materials for the hole-transporting layer having the two-layer structure. This brings about excellent hole injectability and hole transportability, whereby the organic EL element has a low driving voltage.

Brief Description of Drawings

[Fig. 1] The structural formulae of compounds (1-1) to (1-12) as examples of the arylamine compound represented by the general formula (1).

[Fig. 2] The structural formulae of compounds (2-1) to (2-12) as examples of the arylamine compound represented

by the general formula (2).

[Fig. 3] An example of the structure of the organic EL element according to the present invention.

Description of Embodiments

Fig. 1 shows specific preferred examples of the arylamine compound represented by the general formula (1) above and being suitable for use in the organic EL element of the present invention, and Fig. 2 shows specific preferred examples of the arylamine compound represented by the general formula (2) above and being suitable for use in the organic EL element of the present invention. However, compounds suitable for use in the organic EL element of the present invention are not limited to these.

Arylamine compounds represented by the general formulae (1) and (2) can be purified by any purification method such as column chromatography, adsorption using silica gel, activated carbon, activated clay, or the like, recrystallization or crystallization from a solvent, or sublimation. The compounds can be identified by NMR analysis. Preferably, the mobility is measured as a physical property value. The mobility is a measure of hole transportability and hole block-ability. Preferably, the compounds used in the organic EL element of the present invention are purified by, for example, column chromatography, adsorption using silica gel, activated carbon, activated clay, or the like, recrystallization or crystallization from a solvent, or sublimation, and then finally purified by sublimation, before use(see Patent Literature 6, Patent Literature 7, and Patent Literature 8, for example).

The mobility can be measured by time-of-flight spectrometry using a high-sensitivity carrier mobility measuring system (TOF-401 manufactured by Sumitomo Heavy Industries, Ltd.). In time-of-flight spectrometry, an electric field is applied to an element composed of a transparent anode made of ITO, etc., a cathode made of Al, etc., and a thin film of several micrometers made of an organic semiconductor material and sandwiched between the anode and the cathode; carriers are generated in the form of a sheet in the vicinity of the transparent electrode using a pulsed laser; and the time taken for the carriers driven by the applied voltage to reach the cathode is measured and used to calculate the mobility. The mobility is expressed by the equation (C):

$$\mu = L/(tE) \qquad (C)$$

where $\mu$ represents the mobility ($cm^2/Vs$), L represents the thickness (cm) of the thin film, t represents the time (s) taken to reach the cathode, and E represents the electric field (V/cm). The mobility in the present invention is a numerical value at an electric field intensity of 250,000 (V/cm).

The organic EL element of the present invention has at least an anode, a first hole-transporting layer, a second hole-transporting layer, a light-emitting layer, an electron-transporting layer, and a cathode in this order on a substrate. The organic EL element of the present invention may have a hole-injecting layer between the anode and the first hole-transporting layer, and may have a hole-blocking layer between the light-emitting layer and the electron-transporting layer, and may have an electron-injecting layer between the electron-transporting layer and the cathode. For example, a layer serving as both the hole-injecting layer and the first hole-transporting layer may be provided, and a layer serving as both the electron-injecting layer and the electron-transporting layer. It is also possible to stack two first hole-transporting layers, or stack two first hole-transporting layers, or stack two light-emitting layers, or stack two electron-transporting layers, for example. In the organic EL element of the present invention, it is preferable that the second hole-transporting layer should be adjacent to the light-emitting layer and also function as an electron-blocking layer.

An electrode material having a high work function, such as ITO or gold, is used for the anode of the organic EL element of the present invention. Examples of the material for the hole-injecting layer of the organic EL element of the present invention include starburst triphenylamine derivatives and various triphenylamine tetramers; porphyrin compounds typified by copper phthalocyanine; acceptor type heterocyclic compounds such as hexacyanoazatriphenylene; coating type polymer materials. These materials may be used in any known method for forming a thin film, such as vapor deposition or even spin coating or inkjet printing.

Any material that can satisfy the formula (A) above may be used as a hole-transporting material used for the first hole-transporting layer of the organic EL element of the present invention, and examples include: benzidine derivatives such as N,N'-diphenyl-N,N'-di(m-tolyl)benzidine (hereinafter abbreviated as "TPD"), N,N'-diphenyl-N,N'-di($\alpha$-naphthyl)benzidine (hereinafter abbreviated as "NPD"), and N,N,N',N'-tetrabiphenylyl benzidine; 1,1-bis[4-(di-4-tolylamino)phenyl]cyclohexane (hereinafter abbreviated as "TAPC"); and, in particular, arylamine compounds having, in the molecule, a structure containing two triphenylamine structures linked via a single bond or a divalent group having no heteroatom, such as N,N,N',N'-tetrabiphenylyl benzidine. Other examples include arylamine compounds having, in the molecule, a structure containing three or more triphenylamine structures linked via a single bond or a divalent group having no heteroatom, such as various triphenylamine trimers and tetramers. These materials may be used singly to form a film, or any of these may be mixed with another material and used to form a single layer film. These materials

may be used in any known method for forming a thin film, such as vapor deposition or even spin coating or inkjet printing.

It is also possible to use, in the hole-injecting layer or the first hole-transporting layer, a material obtained by p-doping a material normally used for these layers with trisbromophenylamine hexachloroantimony or a radialene derivative (see Patent Literature 5, for example); and a polymer compound having the structure of a benzidine derivative, such as TPD, as a partial structure thereof.

The arylamine compound represented by the general formula (1) or (2) is used as the material for the second hole-transporting layer of the organic EL element of the present invention. Examples of hole transporting materials that can be mixed with, or can be simultaneously used with, the arylamine compound represented by the general formula (1) or (2) include: carbazole derivatives such as 4,4',4"-tri(N-carbazolyl)triphenylamine (TCTA), 9,9-bis[4-(carbazol-9-yl)phenyl]fluorene, 1,3-bis(carbazol-9-yl)benzene (mCP), and 2,2-bis(4-carbazol-9-ylphenyl)adamantane (Ad-Cz); and compounds that have a triphenylsilyl group and a triarylamine structure and are typified by 9-[4-(carbazol-9-yl)phenyl]-9-[4-(triphenylsilyl)phenyl]-9H-fluorene. These materials may be used singly to form a film, or any of them may be mixed with another material and used to form a single layer film. These materials may be used in any known method for forming a thin film, such as vapor deposition or even spin coating or inkjet printing.

The compounds used as the material for the first hole-transporting layer preferably has a mobility $\mu 1$ of $1.5\times10^{-3}$ $cm^2/Vs$ or less, and more preferably $1.0\times10^{-3}$ $cm^2/Vs$ or less.

The compounds used as the material for the second hole-transporting layer preferably has a mobility $\mu 2$ of more than $1.0\times10^{-3}$ $cm^2/Vs$, and more preferably $2.0\times10^{-3}$ $cm^2/Vs$ or more.

In the present invention, the ratio of the mobility of the second hole-transporting layer, $\mu 2$, to the mobility of the first hole-transporting layer, $\mu 1$, (i.e., $\mu 2/\mu 1$) is preferably more than 1.5, more preferably more than 2.0, and even more preferably more than 3.0.

Examples of the materials for the light-emitting layer of the organic EL element of the present invention include: metal complexes of quinolinol derivatives such as $Alq_3$, and various other types of metal complexes; an anthracene derivative, a bisstyrylbenzene derivative, a pyrene derivative, an oxazole derivative, and a poly(p-phenylene vinylene) derivative. The light-emitting layer may also include a host material and a dopant material. As the host material, an anthracene derivative is preferably used. Other examples of the host material include the above-listed light emitting materials, and also a heterocyclic compound having an indole ring as a partial structure of a fused ring, a heterocyclic compound having a carbazole ring as a partial structure of a fused ring, a carbazole derivative, a thiazole derivative, a benzimidazole derivative, and a polydialkylfluorene derivative. As the dopant material, a pyrene derivative is preferably used. Other examples of the dopant material include quinacridone, coumarin, rubrene, perylene, and derivatives thereof; a benzopyran derivative, an indenophenanthrene derivative, a rhodamine derivative, and an aminostyryl derivative. These materials may be used singly to form a film, or any of them may be mixed with another material and used to form a single layer film. Alternatively, the light-emitting layer may have a layered structure composed of different layers each formed of a single kind of the material described above, a layered structure composed of different layers each formed of a mixture of any materials described above, or a layered structure composed of a layer formed of a single kind of the material described above and a layer formed of a mixture of any materials described above.

A phosphorescent emitter can also be used as the light emitting material. The phosphorescent emitter may be a metal complex of iridium, platinum, or the like. A green phosphorescent emitter such as $Ir(ppy)_3$, a blue phosphorescent emitter such as FIrpic or FIr6, or a red phosphorescent emitter such as $Btp_2Ir(acac)$ may be used, and, in this case, carbazole derivatives such as 4,4'-di(N-carbazolyl)biphenyl (CBP), TCTA, and mCP, which are host materials having hole injectability/transportability, can be used as the host material. A host material having electron transportability may also be used, including p-bis(triphenylsilyl)benzene (UGH2) and 2,2',2"-(1,3,5-phenylene)-tris(1-phenyl-1H-benzimidazole) (TPBI). Use of these materials enables production of a high-performance organic EL element.

In order to avoid concentration quenching, doping of a host material with a phosphorescent emitter is preferably performed by co-deposition in an amount within a range of 1 to 30 wt% based on the entire light-emitting layer.

As the light emitting material, a material that emits delayed fluorescence can also be used, including a CDCB derivative such as PIC-TRZ, CC2TA, PXZ-TRZ, and 4CzIPN (see Non-Patent Literature 2, for example).

These materials may be used in any known method for forming a thin film, such as vapor deposition or even spin coating or inkjet printing.

Examples of the materials used for the hole-blocking layer of the organic EL element of the present invention include compounds having a hole-blocking effect, including a phenanthroline derivative, such as bathocuproine (BCP); a metal complex of a quinolinol derivative, such as aluminum(III)bis(2-methyl-8-quinolinato)-4-phenylphenolate (hereinafter abbreviated as BAlq); and also, various types of rare-earth complexes; a triazole derivative; a triazine derivative; and an oxadiazole derivative. These materials may also serve as the material of the electron-transporting layer. These materials may be used singly to form a film, or any of them may be mixed with another material and used to form a single layer film. Alternatively, the hole-blocking layer may have a layered structure composed of different layers each formed of a single kind of the material described above, a layered structure composed of different layers each formed of a mixture of any materials described above, or a layered structure composed of a layer formed of a single kind of the

material described above and a layer formed of a mixture of any the materials described above. These materials may be used in any known method for forming a thin film, such as vapor deposition or even spin coating or inkjet printing.

Examples of the materials used for the electron-transporting layer of the organic EL element of the present invention include metal complexes of quinolinol derivatives, such as $Alq_3$ and BAlq; various types of metal complexes; a triazole derivative; a triazine derivative; an oxadiazole derivative; a pyridine derivative; a pyrimidine derivative; a benzimidazole derivative; a thiadiazole derivative; an anthracene derivative; a carbodiimide derivative; a quinoxaline derivative; a pyridoindole derivative; a phenanthroline derivative; and a silole derivative. These materials may be used singly to form a film, or any of them may be mixed with another material and used to form a single layer film. Alternatively, the electron-transporting layer may have a layered structure composed of different layers each formed of a single kind of the material described above, a layered structure composed of different layers each formed of a mixture of any materials described above, or a layered structure composed of a layer formed of a single kind of the material described above and a layer formed of a mixture of any materials described above. These materials may be used in any known method for forming a thin film, such as vapor deposition or even spin coating or inkjet printing.

Examples of the materials used for the electron-injecting layer of the organic EL element of the present invention include alkali metal salts such as lithium fluoride and cesium fluoride, alkaline earth metal salts such as magnesium fluoride, metal complexes of quinolinol derivatives, such as lithium quinolinol, metal oxides such as aluminum oxide, and metals such as ytterbium (Yb), samarium (Sm), calcium (Ca), strontium (Sr), and cesium (Cs). The electron-injecting layer can be omitted when the electron-transporting layer and the cathode are suitably selected.

Furthermore, it is also possible to use a material obtained by n-doping a material normally used for an electron-injecting layer or an electron-transporting layer with a metal such as cesium.

For the cathode of the organic EL element of the present invention, an electrode material having a low work function, such as aluminum, or an alloy having an even lower work function, such as a magnesium-silver alloy, a magnesium-indium alloy, or an aluminum-magnesium alloy, is used as the electrode material.

## Examples

Hereinafter, embodiments of the present invention will be described in greater detail by way of Examples. However, the present invention is not limited to the examples below.

### Measurement of Mobility

The mobility of each of compounds used in Examples and Comparative Examples were measured in the following manner.

On a Bottom substrate having an ITO film with a thickness of 50 nm formed thereon, the following compound (1-10), (2-3), or (2-10) used as the material for the second hole-transporting layer was vapor-deposited to form a film with a thickness of 4 $\mu$m on the ITO film. On this vapor-deposited film, a film of aluminum with a thickness of 100 nm was then formed as a cathode, to thereby obtain an element. On the prepared element, the mobility was measured using a high-sensitivity carrier mobility measuring system (TOF-401 manufactured by Sumitomo Heavy Industries, Ltd.). Also, mobility was measured for the following compounds (HTM-1) and (HTM-2) each used as the material for the first hole-transporting layer. Furthermore, for comparison, mobility was measured for the following compound (HTM-3) as well. The results are collectively shown below.

[Chem. 4]

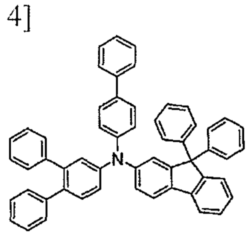

(1-10)

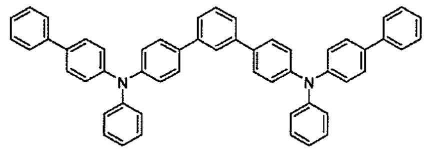

(2-3)

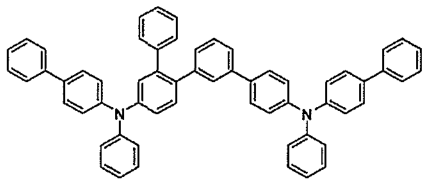

(2-10)

[Chem. 5]

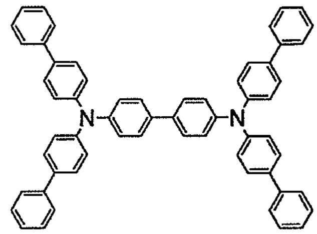

(HTM-1)

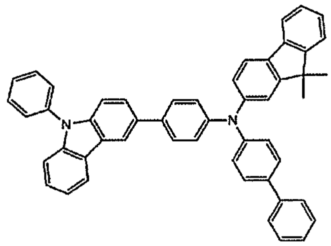

(HTM-2)

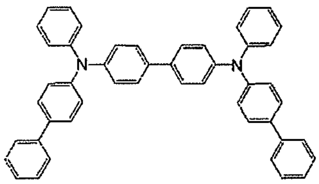

(HTM-3)

The mobilities ($cm^2/Vs$) of the compounds were as follows.

Compound (1-10): $2.63\times10^{-3}$
Compound (2-3): $5.61\times10^{-3}$
Compound (2-10): $3.70\times10^{-3}$
Compound (HTM-1): $8.41\times10^{-4}$
Compound (HTM-2): $5.75\times10^{-4}$
Compound (HTM-3): $8.06\times10^{-4}$

Example 1

An organic EL element was prepared by using the compounds described above, and the properties of the organic EL element were evaluated.

The organic EL element was prepared in the following manner: a reflective ITO electrode serving as a transparent anode 2 was formed on a glass substrate 1 in advance, and furthermore, a hole-injecting layer 3, a first hole-transporting layer 4, a second hole-transporting layer 5, a light-emitting layer 6, an electron-transporting layer 7, an electron-injecting layer 8, a cathode 9, and a capping layer 10 were vapor-deposited in this order on the ITO electrode, as shown in Fig. 3.

Specifically, on a glass substrate 1, an ITO film with a thickness of 50 nm, a reflective silver alloy film with a thickness of 100 nm, and an ITO film with a thickness of 5 nm were formed in this order, and the resulting glass substrate with ITO was ultrasonically cleaned in isopropyl alcohol for 20 minutes, and then dried for 10 minutes on a hot plate

heated to 250°C. After that, UV/ozone treatment was performed for 15 minutes. Then, the glass substrate with ITO was set inside a vacuum vapor deposition machine, and the pressure was reduced to 0.001 Pa or less.

Subsequently, an electron acceptor (Acceptor-1) having the structural formula below and the compound (HTM-1) were vapor-deposited so as to cover the transparent anode 2 through binary vapor deposition at vapor deposition rates such that the ratio of the vapor deposition rate of Acceptor-1 to the vapor deposition rate of the compound (HTM-1) was 3:97, to thereby form the hole-injecting layer 3 with a thickness of 10 nm.

On this hole-injecting layer 3, the first hole-transporting layer 4 (thickness: 140 nm) made of the compound (HTM-1) was formed.

On this first hole-transporting layer 4, the second hole-transporting layer 5 (thickness: 5 nm) made of the compound (1-10) was formed.

On this second hole-transporting layer 5, the compound (EMD-1) having the structural formula below and a compound (EMH-1) having the structural formula below were vapor-deposited through binary vapor deposition at vapor deposition rates such that the ratio of the vapor deposition rate of the compound (EMD-1) to the vapor deposition rate of the compound (EMH-1) was 5:95, to thereby form the light-emitting layer 6 with a thickness of 20 nm.

On this light-emitting layer 6, a compound (ETM-1) having the structural formula below and a compound (ETM-2) having the structural formula below were vapor-deposited through binary vapor deposition at vapor deposition rates such that the ratio of the vapor deposition rate of the compound (ETM-1) to the vapor deposition rate of the compound (ETM-2) was 50:50, to thereby form the electron-transporting layer 7 with a thickness of 30 nm.

On this electron-transporting layer 7, the electron-injecting layer 8 (thickness: 1 nm) made of lithium fluoride was formed.

On this electron-injecting layer 8, a cathode 9 (thickness: 12 nm) made of a magnesium-silver alloy was formed.

Finally, the capping layer 10 (thickness: 60 nm) made of a compound (CPL-1) having the structural formula below was formed.

For the prepared organic EL element, Table 1 collectively shows the mobility of the second hole-transporting layer (μ2) and the mobility of the first hole-transporting layer (μ1), which are the found values in "mobility measurement" above, as well as the result of calculation of the ratio of the mobility of the second hole-transporting layer to the mobility of the first hole-transporting layer (μ2/μ1). Also, Table 2 collectively shows the measurement results of light emission characteristics of the prepared organic EL element when a DC voltage was applied thereto in the atmosphere at normal temperature.

[Chem. 6]

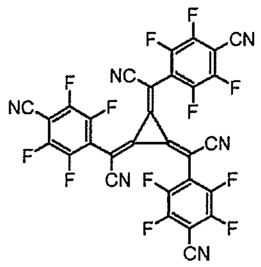

(Acceptor-1)

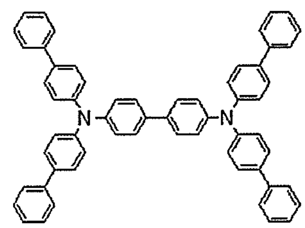

(HTM-1)

[Chem. 7]

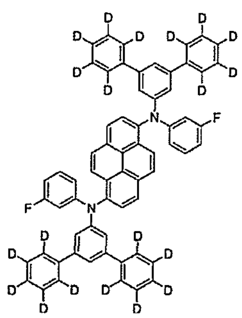

(EMD-1)

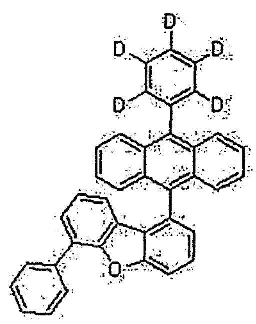

(EMH-1)

[Chem. 8]

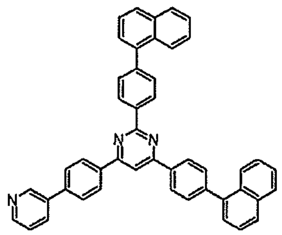

(ETM-1)

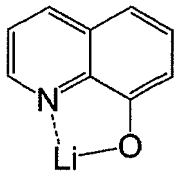

(ETM-2)

[Chem. 9]

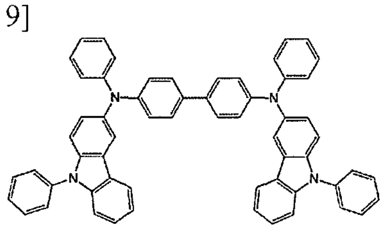

(CPL-1)

Example 2

An organic EL element was prepared in the same manner as in Example 1, except that, instead of the compound (1-10), the compound (2-3) was used as the material of the second hole-transporting layer 5. For the prepared organic EL element, Table 1 collectively shows the ratio of the mobility of the compound (2-3) of the second hole-transporting layer to the mobility of the compound (HTM-1) of the first hole-transporting layer ($\mu 2/\mu 1$). Also, Table 2 collectively shows the measurement results of light emission characteristics of the prepared organic EL element when a DC voltage was applied thereto in the atmosphere at normal temperature.

Example 3

An organic EL element was prepared in the same manner as in Example 1, except that, instead of the compound (1-10), the compound (2-10) was used as the material of the second hole-transporting layer 5. For the prepared organic EL element, Table 1 collectively shows the ratio of the mobility of the compound (2-10) of the second hole-transporting layer to the mobility of the compound (HTM-1) of the first hole-transporting layer ($\mu 2/\mu 1$). Also, Table 2 collectively shows the measurement results of light emission characteristics of the prepared organic EL element when a DC voltage was applied thereto in the atmosphere at normal temperature.

Example 4

An organic EL element was prepared in the same manner as in Example 1, except that, instead of the compound (HTM-1), the compound (HTM-2) was used as the material of the hole-injecting layer 3 and the first hole-transporting layer 4. For the prepared organic EL element, Table 1 collectively shows the ratio of the mobility of the compound (1-10) of the second hole-transporting layer to the mobility of the compound (HTM-2) of the first hole-transporting layer ($\mu 2/\mu 1$). Also, Table 2 collectively shows the measurement results of light emission characteristics of the prepared organic EL element when a DC voltage was applied thereto in the atmosphere at normal temperature.

Example 5

An organic EL element was prepared in the same manner as in Example 2, except that, instead of the compound (HTM-1), the compound (HTM-2) was used as the material of the hole-injecting layer 3 and the first hole-transporting layer 4. For the prepared organic EL element, Table 1 collectively shows the ratio of the mobility of the compound (2-3) of the second hole-transporting layer to the mobility of the compound (HTM-2) of the first hole-transporting layer ($\mu 2/\mu 1$). Also, Table 2 collectively shows the measurement results of light emission characteristics of the prepared organic EL element when a DC voltage was applied thereto in the atmosphere at normal temperature.

Example 6

An organic EL element was prepared in the same manner as in Example 3, except that, instead of the compound (HTM-1), the compound (HTM-2) was used as the material of the hole-injecting layer 3 and the first hole-transporting layer 4. For the prepared organic EL element, Table 1 collectively shows the ratio of the mobility of the compound (2-10) of the second hole-transporting layer to the mobility of the compound (HTM-2) of the first hole-transporting layer ($\mu 2/\mu 1$). Also, Table 2 collectively shows the measurement results of light emission characteristics of the prepared organic EL element when a DC voltage was applied thereto in the atmosphere at normal temperature.

Comparative Example 1

For comparison, an organic EL element was prepared in the same manner as in Example 1, except that, instead of the compound (1-10), the compound (HTM-3) was used as the material of the second hole-transporting layer 5. For the prepared organic EL element, Table 1 collectively shows the ratio of the mobility of the compound (HTM-3) of the second hole-transporting layer to the mobility of the compound (HTM-1) of the first hole-transporting layer ($\mu 2/\mu 1$). Also, Table 2 collectively shows the measurement results of light emission characteristics of the prepared organic EL element when a DC voltage was applied thereto in the atmosphere at normal temperature.

Comparative Example 2

For comparison, an organic EL element was prepared in the same manner as in Example 4, except that, instead of the compound (1-10), the compound (HTM-3) was used as the material of the second hole-transporting layer 5. For the prepared organic EL element, Table 1 collectively shows the ratio of the mobility of the compound (HTM-3) of the second hole-transporting layer to the mobility of the compound (HTM-2) of the first hole-transporting layer ($\mu 2/\mu 1$). Also, Table 2 collectively shows the measurement results of light emission characteristics of the prepared organic EL element when a DC voltage was applied thereto in the atmosphere at normal temperature.

Table 1

| | First hole-transporting layer | Second hole-transporting layer | $\mu 1$ ($cm^2/Vs$) | $\mu 2$ ($cm^2/Vs$) | $\mu 2/\mu 1$ |
|---|---|---|---|---|---|
| Ex. 1 | Compound (HTM-1) | Compound (1-10) | $8.41\times10^{-4}$ | $2.63\times10^{-3}$ | 3.1 |
| Ex. 2 | Compound (HTM-1) | Compound (2-3) | $8.41\times10^{-4}$ | $5.61\times10^{-3}$ | 6.7 |
| Ex. 3 | Compound (HTM-1) | Compound (2-10) | $8.41\times10^{-4}$ | $3.70\times10^{-3}$ | 4.4 |
| Ex. 4 | Compound (HTM-2) | Compound (1-10) | $5.75\times10^{-4}$ | $2.63\times10^{-3}$ | 4.6 |
| Ex. 5 | Compound (HTM-2) | Compound (2-3) | $5.75\times10^{-4}$ | $5.61\times10^{-3}$ | 9.8 |
| Ex. 6 | Compound (HTM-2) | Compound (2-10) | $5.75\times10^{-4}$ | $3.70\times10^{-3}$ | 6.4 |
| Com. Ex. 1 | Compound (HTM-1) | Compound (HTM-3) | $8.41\times10^{-4}$ | $8.06\times10^{-4}$ | 1.0 |
| Com. Ex. 2 | Compound (HTM-2) | Compound (HTM-3) | $5.75\times10^{-4}$ | $8.06\times10^{-4}$ | 1.4 |

As shown in Table 1, in the hole-transporting layer of each of the elements of Examples 1 to 6, the compound of the second hole-transporting layer had a mobility of $2.0\times10^{-3}$ $cm^2/Vs$ or more, which means that the general formula (A) was satisfied, and the ratio of the mobility of the second hole-transporting layer to the mobility of the first hole-transporting layer ($\mu 2/\mu 1$) was more than 3.0, which means that the general formula (B) was satisfied. On the other hand, in the hole-transporting layer of each of the elements of Comparative Examples 1 and 2, the compound of the second hole-transporting layer had a mobility of $1.0\times10^{-3}$ $cm^2/Vs$ or less, and the ratio of the mobility of the second hole-transporting layer to the mobility of the first hole-transporting layer ($\mu 2/\mu 1$) was less than 1.5, which means that the general formulae (A) and (B) were not satisfied.

The values of the voltage, luminance, luminance efficiency, and power efficiency, which are collectively shown in Table 2, were obtained when a current at a current density of 10 $mA/cm^2$ was applied to the elements in the atmosphere at normal temperature. The element lifespan was defined as follows: the organic EL element was driven by constant current to emit light at an initial luminance (the luminance when light emission started) of 2,000 $cd/m^2$, and the time taken for the luminance to decay to 1,900 $cd/m^2$ (corresponding to 95% based on the initial luminance (100%): 95% decay) was determined and used as the element lifespan.

Table 2

| | Voltage (V) | Luminance ($cd/m^2$) | Luminance efficiency (cd/A) | Power efficiency (lm/W) | Element lifespan (h) |
|---|---|---|---|---|---|
| Ex. 1 | 3.48 | 829 | 8.29 | 7.50 | 440 |
| Ex. 2 | 3.50 | 832 | 8.32 | 7.48 | 453 |
| Ex. 3 | 3.51 | 840 | 8.40 | 7.52 | 429 |
| Ex. 4 | 3.41 | 820 | 8.20 | 7.55 | 383 |
| Ex. 5 | 3.44 | 869 | 8.67 | 7.90 | 398 |
| Ex. 6 | 3.46 | 838 | 8.39 | 7.63 | 371 |
| Com. Ex. 1 | 3.67 | 767 | 7.66 | 6.56 | 263 |
| Com. Ex. 2 | 3.59 | 794 | 7.94 | 6.94 | 279 |

As shown in Table 2, when a current at a current density of 10 $mA/cm^2$ was applied to the elements, the voltages across the elements of Comparative Examples 1 and 2 were 3.59 to 3.67 V, whereas the voltages across the elements of Examples 1 to 6 were 3.41 to 3.51 V, which are clearly lower voltages. When a current at a current density of 10 $mA/cm^2$ was applied to the elements, the luminance efficiency values of the elements of Comparative Examples 1 and 2 were 7.66 to 7.94 cd/A, whereas the luminance efficiency values of the elements of Examples 1 to 6 were 8.20 to 8.67 cd/A, which indicate clearly high efficiency. The power efficiency values of the elements of Comparative Examples 1 and 2 were 6.56 to 6.94 lm/W, whereas the power efficiency values of the elements of Examples 1 to 6 were 7.48 to 7.90 lm/W, which indicate clearly higher efficiency. Furthermore, the element lifespans (95% decay) of the elements of Comparative Examples 1 and 2 were 263 to 279 hours, whereas the element lifespans of the elements of Examples 1 to 6 were 371 to 453 hours, which are considerably longer lifespans.

It can be seen from the above results that an organic EL element of the present invention, which has the second hole-transporting layer including an arylamine compound having a specific structure represented by the general formula (1) or (2) and satisfies the general formulae (A) and (B), has a lower driving voltage, higher luminance efficiency, and a longer lifespan, compared with the conventional organic EL elements of Comparative Examples, which do not satisfy the general formulae (A) and (B).

Industrial Applicability

An organic EL element of the present invention, which includes a hole-transporting layer having a two-layer structure in which an arylamine compound having a specific structure is used for the second hole-transporting layer and also satisfies the general formulae (A) and (B), has increased luminance efficiency and improved durability compared with a conventional organic EL element, and can therefore be applied to uses such as home electric appliances and lighting equipment.

List of Reference Numerals

1 Glass substrate
2 Transparent anode
3 Hole-injecting layer
4 First hole-transporting layer
5 Second hole-transporting layer
6 Light-emitting layer
7 Electron-transporting layer
8 Electron-injecting layer
9 Cathode
10 Capping layer

## Claims

1. An organic electroluminescent element having at least an anode, a first hole-transporting layer, a second hole-transporting layer, a light-emitting layer, an electron-transporting layer, and a cathode in this order,

   wherein the second hole-transporting layer contains an amine compound represented by the general formula (1) or (2) below, and
   a mobility of the first hole-transporting layer, μ1, and a mobility of the second hole-transporting layer, μ2, satisfy the formulae (A) and (B) below simultaneously:

$$\mu 2 > 1.0\times10^{-3}\ cm^2/Vs \qquad (A),$$

   and

$$\mu 2/\mu 1 > 1.5 \qquad (B),$$

[Chem. 1]

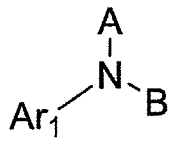

(1)

   wherein, A and B may be the same or different and each represent a monovalent group represented by the general formula (1-1) below; and
   $Ar_1$ represents a substituted or unsubstituted aromatic hydrocarbon group or a substituted or unsubstituted fused polycyclic aromatic group,

[Chem. 2]

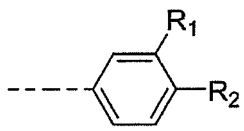

(1−1)

   wherein the dashed line represents a binding site;
   $R_1$ and $R_2$ may be the same or different and each represent a hydrogen atom, a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted fused polycyclic aromatic group, or a substituted or unsubstituted aryloxy group; and
   $R_1$ and $R_2$ are optionally bonded to each other via a single bond, a substituted or unsubstituted methylene group, an oxygen atom, or a sulfur atom to form a ring,

[Chem. 3]

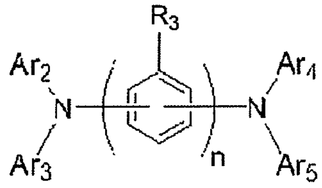

(2)

wherein $Ar_2$, $Ar_3$, $Ar_4$, and $Ar_5$ may be the same or different and each represent a substituted or unsubstituted aromatic hydrocarbon group or a substituted or unsubstituted fused polycyclic aromatic group;
$R_3$ represents a hydrogen atom, a substituted or unsubstituted aromatic hydrocarbon group, or a substituted or unsubstituted fused polycyclic aromatic group, and when there are plural $R_3$, they may be the same or different; and
n represents an integer of 1 to 5.

**2.** The organic electroluminescent element according to claim 1, wherein, in the monovalent group represented by the general formula (1-1), $R_1$ and $R_2$ may be the same or different and each represent a hydrogen atom, a substituted or unsubstituted aromatic hydrocarbon group having 6 or 30 carbon atoms or a substituted or unsubstituted fused polycyclic aromatic group having 6 to 30 carbon atoms.

**3.** The organic electroluminescent element according to claim 1, wherein, in amine compounds represented by the general formulae (1) and (2), $Ar_1$, $Ar_2$, $Ar_3$, $Ar_4$, and $Ar_5$ are the same or different and each represent a substituted or unsubstituted aromatic hydrocarbon group having 6 to 30 carbon atoms or a substituted or unsubstituted fused polycyclic aromatic group having 6 to 30 carbon atoms.

**4.** The organic electroluminescent element according to claim 1, wherein the mobility of the first hole-transporting layer, $\mu 1$, is $1.5 \times 10^{-3}$ $cm^2/Vs$ or less.

**5.** The organic electroluminescent element according to claim 1, wherein the mobility of the second hole-transporting layer, $\mu 2$, is $2.0 \times 10^{3}$ $cm^2/Vs$ or more.

**6.** The organic electroluminescent element according to any one of claims 1 to 5, wherein the first hole-transporting layer has a film thickness of more than 30 nm and less than 200 nm, and the second hole-transporting layer has a film thickness of more than 3 nm and less than 20 nm.

Fig. 1

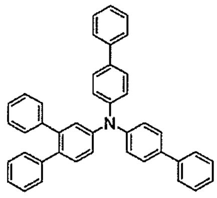

(1-1)

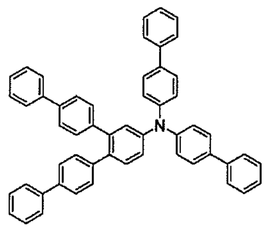

(1-2)

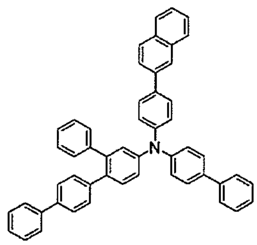

(1-3)

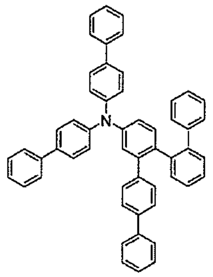

(1-4)

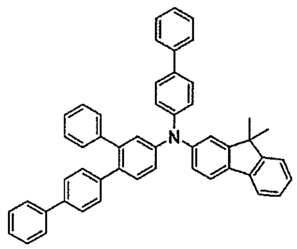

(1-5)

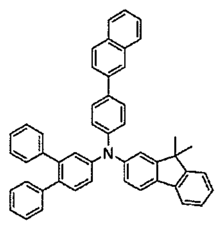

(1-6)

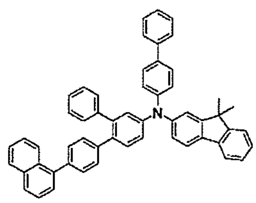

(1-7)

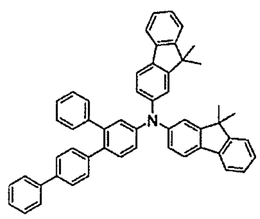

(1-8)

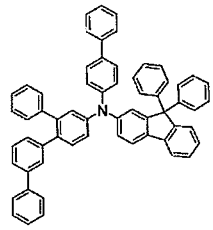

(1-9)

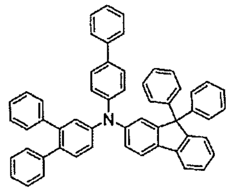

(1-10)

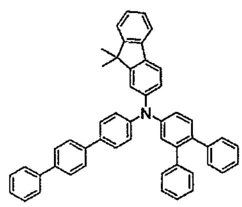

(1-11)

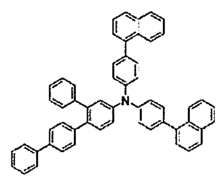

(1-12)

Fig. 2

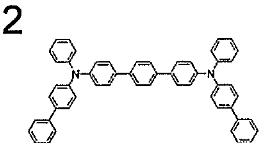

(2－1)

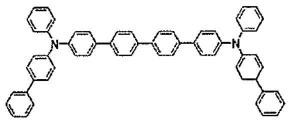

(2－2)

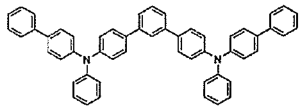

(2－3)

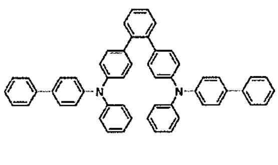

(2－4)

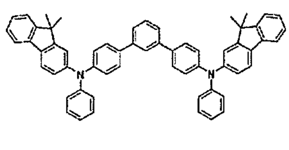

(2－5)

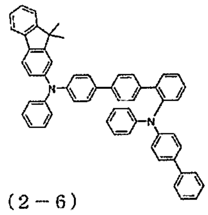

(2－6)

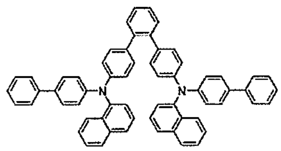

(2－7)

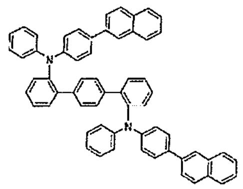

(2－8)

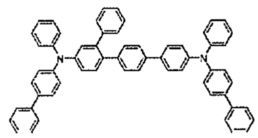

(2－9)

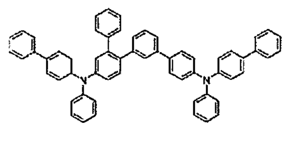

(2－10)

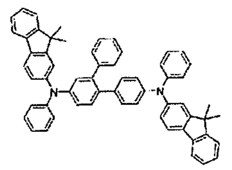

(2－11)

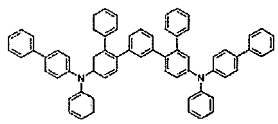

(2－12)

Fig. 3

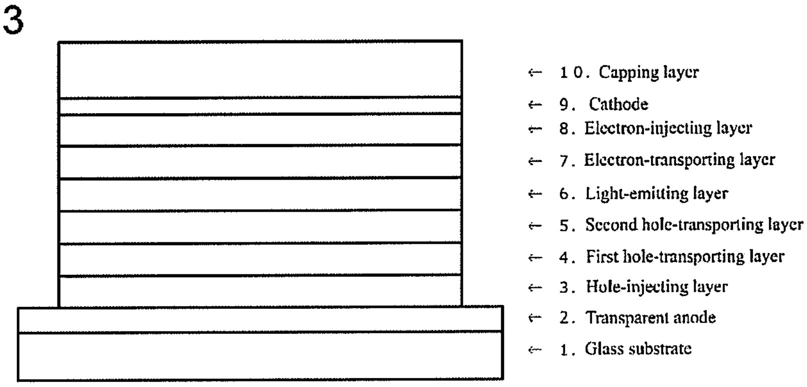

**INTERNATIONAL SEARCH REPORT**

International application No. **PCT/JP2022/033264**

**A. CLASSIFICATION OF SUBJECT MATTER**

***H01L 51/50***(2006.01)i
FI: H05B33/22 D; H05B33/14 A

According to International Patent Classification (IPC) or to both national classification and IPC

**B. FIELDS SEARCHED**

Minimum documentation searched (classification system followed by classification symbols)

H01L51/50

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2018/168991 A1 (HODOGAYA CHEMICAL CO., LTD.) 20 September 2018 (2018-09-20) claims (in particular, claims 3-6), paragraphs [0666], [0667], [0669], [0677], [0678], [0705], table 1, example 47 (first hole transport layer; compound (4-1) / second hole transport layer; compound (1-165)) | 1–6 |
| X | WO 2016/006629 A1 (HODOGAYA CHEMICAL CO., LTD.) 14 January 2016 (2016-01-14) claims (in particular, claims 8-14), paragraphs [0195], [0251]-[0255], [0275], [0300], table 1, example 56 (first hole transport layer; compound (3-1) / second hole transport layer; compound (1-143)) | 1–6 |
| A | US 2013/0313535 A1 (LG DISPLAY CO., LTD.) 28 November 2013 (2013-11-28) entire text, all drawings | 1–6 |
| A | KR 10-2021-0106037 A (SAMSUNG DISPLAY CO., LTD.) 30 August 2021 (2021-08-30) entire text, all drawings | 1–6 |
| A | US 2015/0115231 A1 (SAMSUNG DISPLAY CO., LTD.) 30 April 2015 (2015-04-30) entire text, all drawings | 1–6 |

☐ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **30 September 2022** | **11 October 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/033264**

| Patent document cited in search report | Publication date (day/month/year) | Patent family member(s) | Publication date (day/month/year) |
|---|---|---|---|
| WO 2018/168991 A1 | 20 September 2018 | US 2021/0143326 A1 claims (in particular, claims 3-6), paragraphs [0273], [0274], [0276], [0296], table 1, example 47 (first hole transport layer; compound (4-1) / second hole transport layer; compound (1-165)) | |
| | | EP 3598516 A1 | |
| | | CN 110431680 A | |
| | | KR 10-2019-0128659 A | |
| | | TW 201839096 A | |
| WO 2016/006629 A1 | 14 January 2016 | US 2017/0179398 A1 claims (in particular, claims 8-14), paragraphs [0534], [0667]-[0671], [0708], [0757], table 1, example 56 (first hole transport layer; compound (3-1) / second hole transport layer; compound (1-143)) | |
| | | EP 3168887 A1 | |
| | | KR 10-2017-0028406 A | |
| | | CN 106688119 A | |
| | | TW 201610089 A | |
| US 2013/0313535 A1 | 28 November 2013 | KR 10-2013-0130574 A | |
| | | CN 103426902 A | |
| KR 10-2021-0106037 A | 30 August 2021 | (Family: none) | |
| US 2015/0115231 A1 | 30 April 2015 | KR 10-2015-0049257 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 5792557 A
- US 5639914 A
- US 8021764 B2
- US 8394510 B2
- WO 2014009310 A
- US 20190006596 A1
- US 20160118591 A1
- US 20170179398 A1


### Non-patent literature cited in the description


- **C. W. TANG et al.** *Eastman Kodak Company,* 1987
- *Proceedings of the 9th Meeting of the Japan Society of Applied Physics,* 2001, 55-61
- *Appl. Phys. Let.,* 2011, vol. 98, 083302
- *Proceedings of the 3rd Meeting of the Japan OLED Forum,* 2006, 13-14